# EUROPEAN PATENT APPLICATION

(11) **EP 2 159 583 A1**
(43) Date of publication of application: **03.03.2010**
(21) Application number: 08015294.5
(22) Date of filing: 29.08.2008
(51) Int. Cl.: G01R 31/26, H01L 31/18

(54) **System and method for localizing and passivating defects in a photovoltaic element**

(71) Applicant: ODERSUN Aktiengesellschaft, 15236 Frankfurt (Oder) (DE)
(72) Inventor: Tober, Olaf, 10437 Berlin (DE)
(74) Representative: Emmerling, Friedrich

(57) **Abstract**

The present invention relates to a system and method for localizing defects causing leakage currents in a photovoltaic element (100), a system and method for passivating defects causing leakage currents in a photovoltaic element and a system and method for passivating a shunt in a roll-to-roll photovoltaic element comprising the steps of illuminating an area (130), having at least a minimum size, of the photovoltaic element; measuring at least one electrical value of an electrical potential between electrodes of the photovoltaic element at at least one specific measurement position within the illuminated area on one of the electrodes of the photovoltaic element; and determining a position of a defect based on the measured at least one photoinduced electrical value and the at least one specific measurement position.

## Description

### FIELD OF THE INVENTION

The present invention relates to a system and method for localizing defects causing leakage currents in a photovoltaic element, a system and method for passivating defects causing leakage currents in a photovoltaic element and a system and method for passivating a shunt in a roll-to-roll photovoltaic element.

### DESCRIPTION OF THE RELATED ART

Photovoltaics will play a major role for the world-wide power generation. This young Technology has to demonstrate its superiority regarding other energy conversion technologies at the market. The decision issue will be the price per unit of solar panels to capture a significant market share. Additionally, the share in several market segments will define special adapted properties of the solar panels. For building applications aesthetics, low price per m² and flexibility in shape and size may be important issues, for solar home systems lightweight and fracture-proof solar panels at the lowest price per Ah are needed. Furthermore, the manufacturers are looking for robust processes and the possibility to produce large area panels. They need the advantages of high production throughput and low maintenance as well as high automation and moderate investments. Therefore, future technologies must be available, which guarantee a high scientific recognition, a fully developed equipment, a high cost reduction potential with low material consumption and an outlook to increase the efficiency.

Currently, crystalline silicon technologies obtain the best compromise to meet the above mentioned demands hence the market for photovoltaic solar cells and panels is still dominated by crystalline silicon products. In these technologies solar cells with a thickness of approx. 0.3 mm were manufactured on small areas of 0.03 m². The electrical joining of these cells in a separate process results in the creation of large surfaces. Unfortunately these products are expensive because of the high consumption of silicon and the complex manufacturing processes. New technologies, especially low-cost thin film technologies, can gain an increasing share of the market in the coming years. These concepts use another procedure to produce solar modules at far lower costs. They try to deposit the solar cells of only few µm in thickness directly onto large surfaces, mainly glass, and then to interconnect parts of them in series by inline laser cutting processes. A uniform deposition of the individual metal and semiconductor layers over the whole surface is a decisive prerequisite for homogeneous photoelectric properties. The current developments show that long times are needed to adapt the processes developed in the laboratory on module areas of approx. 10 cm² to larger ones. Larger surfaces need new parameter sets and the number of inhomogeneities increases which causes a lower efficiency. The size of the vacuum coating installation defines the size of the solar panels, and any increase in size requires new production installations and new optimisation of all process parameters.

The thin film CISCuT technology, CIS on Cu Tape, offers the capability to produce solar modules at a far lower cost than those from crystalline silicon and to overcome the specific difficulties of the common thin film concepts such as large-area homogeneity and long terms and high investments for scaling up. CISCuT is a reel-to-reel technology, working in a series of mainly non vacuum processes, treated on metal foils of 1 cm in width, yielding a quasi endless solar cell tape. Mechanically flexible, uniform anthracite-like coloured solar laminates will be produced by interconnecting the overlapped tape stripes and embedded into functional foils. In this thin film concept, the equipment for the solar cell production is fully independent of shape and size of the solar modules, changes in module sizes do not need any changes or up-scaling of the production equipment.

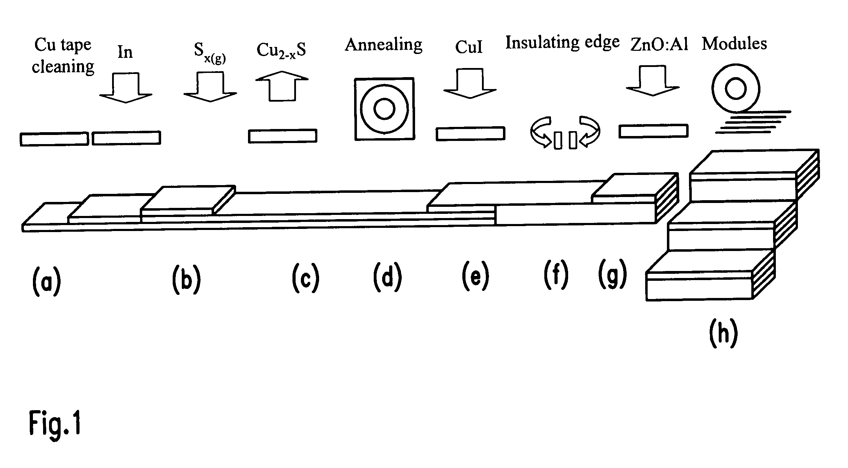

Fig. 1 shows a set up for the fabrication of quasi endless solar cells in consecutive reel-to-reel processes and assembling afterwards modules from these cells which are e.g. described in Güldner, R., Penndorf, J., Winkler, M., Tober, O., 2000 Flexible, Polymer Encapsulated Solar Modules - A New Concept for Cu-In-S Solar Devices Produced by the CISCuT Technology Proc. 16th EPSEC, Glasgow, UK, pp. 2289 - 2292. The basic steps of the production of solar cells is e.g. described in M. Winkler, J., Griesche, J., Konovalov, I.; Penndorf J., Wienke, J., Tober, O., "CISCuT - solar cells and modules on the basis of CuInS2 on Cu-tape", Solar Energy 77, 2004, pp. 705 -716 and . M. Winkler, J., Griesche, J., Konovalov, I.; Penndorf J., Tober, O., "Design, Actual Performance, and Electrical Stability of CISCuT-Based Quasi-Endless Solar Cell Tapes", Mat. Res. Soc. Symp. Proc 2001, pp. 668.

It consists of:
*(a) Tape cleaning and In deposition:* In the first roll-to-roll process, the Cu tape of 1 cm in width is chemically cleaned followed by some rinsing processes. Then Indium is electrochemically deposited on the front side of the tape only. The thickness of the In-layer is in the range of 0.7 µm. The homogeneity of the In-layer thickness of ± 5% is due for local stationary starting conditions and precursor properties, especially the homogeneous Cu-concentration.
*(b) Absorber layer formation (Sulphurisation):* A solid Cu-In-S layer is formed by partial conversion of the In-Cu precursor into the CISCuT-absorber when the tape is exposed to reactive gaseous sulphur inside the sulphurisation reactor. The dynamic of the reel-to-reel process on a tape substrate is connected with stationary thermal and chemical conditions at each place of the whole reactor by computer assisted control of the basic essential technical parameter as tape velocity, heater temperatures, pressure and nitrogen flow (Winkler et al., 2001).
*(c) KCN-etching:* Generally, the absorber layer surface must be treated with a KCN-solution to remove Cu₂₋ₓS from the surface.
*(d) Annealing:* The tape will be annealed on spool in high vacuum at moderate temperatures for 30 minutes.
*(e) Buffer layer deposition:* A wide band gap p-type CuI buffer layer with a thickness of about 70 nm is obtained by spraying CuI dissolved in Acetonitrile (0.4 g in 80 ml) onto the absorber surface at a temperature of about 80°C.
*(f) Edge insulating:* The edges of the tape are covered by an insulating glassy layer of Nanomere solution to making possible the roof tile interconnection during module assembling at the end.
*(g) TCO deposition:* A TCO stack is deposited by DC sputtering as a transparent front contact. At first an intrinsic layer of a thickness of 100 nm is deposited followed by the deposition of a high conductive layer with a thickness of 1 µm. The conductivity has been changed by means of variation of the oxygen pressure during the sputtering process. The target is 2% Al doped ZnO, the temperature of the tape is 165°C, thus achieving a transmittance of about 90%. The result is a quasi-endless flexible tape-like CISCuT based solar cell, ready for module assembling.
*(h) Module assembling:* In an automated assembly line a defined number of stripes of the quasi-endless flexible tape is imbedded into the front side foil and electrically connected in series "roof tile like", by overlapping. The overlapped region is in the range of 1mm. As contacting material metal filled glues are used. Current collection grids at the transparent front side contact are unnecessary. The roof tile interconnection of solar cell stripes to strings of defined voltage (number of stripes), of defined current (length of stripes), and the interconnection of the strings in parallel by using bus bars with definition of output power works, as described previously as a concept (Güldner et al., 2000). Front and back side encapsulated into function foils, flexible modules are obtained which are adaptable in output power, shape and size.

As mentioned above, the price per unit of solar panels in regard to generated electrical power has an important impact on the respective photovoltaic technology. This means that on the one side efficient mass production of the solar cells has to be established, and on the other side the efficiency of the produced solar cells has to be carefully controlled. Maximum achievable efficiency varies in dependence of the solar cell technology. Once a specific solar cell technology has been defined for a production process the efficiency of the mass-produced solar cells strongly depends on the quality of the production process.

One reason for a reduced efficiency in a solar cell might be a defect in the solar cell, which causes a leakage current. Such an effect is also called shunt. Low shunt resistance therefore causes power losses in the solar cell, as it provides an alternate current path for the light-generated current. Such a diversion reduces the amount of currents flowing from the solar cell junction and reduces the voltage from the solar cell.

Therefore, it would be desirable to produce solar cells without shunts. However, this would increase the production costs drastically.

### SUMMARY OF THE INVENTION

Therefore, it is the object of the present invention to provide a system and method for localizing defects causing leakage currents in a photovoltaic element. Once the defect is localized, it can be passivated, thus, eliminating the leakage current produced by the localized shunt. In such a way the shunt resistance is increased and the power loss in the photovoltaic element is reduced.

This object is solved by the present invention and in particular by the subject matter of the independent claims preferred embodiments are subject matter of the dependent claims.

For this purpose, in accordance with an aspect of the present invention, there is provided a method for localizing defects causing leakage currents in a photovoltaic element comprising illuminating an area, having at least a minimum size, of the photovoltaic element, measuring at least one photoinduced electrical value by contacting two electrodes of the illuminated photovoltaic element preferably independently on the size of the illuminated area at at least one specific measurement position within the illuminated area on one of the electrodes of the photovoltaic element and determining the position of the defect of the photovoltaic element, based on the measured at least one photoinduced electrical value and at least one specific measurement position. Preferably, the measured electrical value of the electrical potential between the electrodes is a photoinduced electrical value, which is measured via at least one measuring contact on one of the electrodes of the photovoltaic element. Additionally, the photovoltaic element is electrically contacted on the other electrode for measuring the photoinduced electrical value. The photovoltaic element is moved in relation to the at least one measuring contact for measuring a number of photoinduced electrical values at different measurement positions wherein the area, having at least a minimum size, is illuminated in a fixed relationship to the position of the measuring contact.

Still additionally, the photovoltaic element preferably is moved at a speed of up to 15 m/min and photoinduced electrical values are determined at least every 50 µm.

Alternatively, the at least one measuring contact preferably is moved in relation to the photovoltaic element to the at least one specific measurement position on the electrode for measuring photoinduced electrical values.

Yet additionally, the method according to the present invention preferably comprises storing the measured at least one photoinduced electrical value in correlation with the at least one specific measurement position.

Yet additionally, the method according to the present invention preferably further comprises determining a position-dependent voltage profile for an electrical potential based on the measured at least one photoinduced electrical value and the corresponding at least one specific measurement position and determining a minimum or maximum of the position dependent voltage profile and providing a position of the determined minimum or maximum as a position of the defect, wherein two measuring contacts spaced apart from each other positioned on one electrode and another contact positioned on the other electrode are used for measuring photoinduced electrical values. The measured photoinduced electrical values are separately stored in correlation with the specific measurement positions for each of the measuring contacts, position-dependent voltage profiles are separately determined based on a number of measured photoinduced electrical values and corresponding specific measurement positions for each of the measuring contacts, and the minimum of each of the position-dependent voltage profiles is separately determined based on calculated differential values of the measured photoinduced electrical values and the corresponding specific measurement positions for each of the measuring contacts.

Preferably, such a differential value of the measured photoinduced electrical values is separately calculated for each of the measuring contacts by determining the difference between a first-measured photoinduced electrical value and a second-measured photoinduced electrical value preceding the first-measured photoinduced electrical value.

Furthermore, the method according to the present invention preferably further comprises storing the determined minimum as a position of the defect in a storage medium with regard to the photovoltaic element.

Yet additionally, the method according to the present invention preferably further comprises electrically passivating the defect for which the position has been determined, wherein at least one part of one electrode is removed in an area at the determined position of the defect. Preferably, one of the electrodes is a TCO layer and the passivation of the determined defect is performed via locally removing the TCO layer. Preferably, the TCO layer is a ZnO:Al layer which is removed via chemical etching or via laser etching. In the case of laser etching, preferably a line with a specific width is drawn around each of determined defects via laser etching wherein along the line the TCO layer is removed thereby ensuring that after the passivation step the TCO layer in electrical contact with the defects for which the positions have been determined has no electrical contact to the remaining TCO layer used as an electrode. Additionally, two or more defects for which the positions have been determined and which positions are next to each other can be identified as a cluster of defects. Then, the line with the specific width is preferably drawn around the cluster of defects via laser etching.

Preferably, the method according to the present invention is applied to a roll-to-roll thin-film solar cell and the illuminated area, having at least a minimum size of 1x1 cm².

Moreover, in accordance with another aspect of the present invention, there is provided a method for passivating defects causing leakage currents in a photovoltaic element which comprises illuminating an area, having at least a minimum size, of the photovoltaic element, determining a position of a defect based on at least one photoinduced electrical value of an electrical potential between electrodes of the photovoltaic element and a corresponding measurement position within the illuminated area on one of the electrodes of the photovoltaic element, and removing at least one of the electrodes in an area at the determined position of the defect via etching. Preferably, the etching is performed via laser etching. Alternatively, the etching is performed via chemical etching, pad printing and or jet printing. The at least one of the electrodes is removed along a line with a predetermined width by a laser in the area at the determined position thereby electrically isolating the defect.

In accordance with yet another aspect of the present invention there is provided a method for localizing defects causing leakage currents in a photovoltaic element comprising the steps of illuminating an area of the photovoltaic element, measuring at least one value of an electrical potential between electrodes of the photovoltaic element at at least one specific measurement position within the illuminated area on one of the electrodes of the photovoltaic element; and determining a position of a defect based on the measured at least one voltage value and the at least one specific measurement position.

Furthermore, in accordance with still another aspect of the present invention, there is provided a method for passivating a shunt in a roll-to-roll photovoltaic element including a TCO layer as a front electrode. This method comprises determining a position of a shunt in the photovoltaic element, positioning the photovoltaic element at the determined position and removing the TCO layer in an area at the determined position of the shunt via etching thereby ensuring that the shunt has no electrical contact to the front electrode after removing the TCO layer. Preferably, the TCO layer is only partially removed around the shunt. Furthermore, the etching is performed via laser etching and the TCO layer around the determined position of the shunt is removed along a line with a predetermined width by a laser thereby electrically isolating the shunt. Alternatively, the etching is performed via chemical etching.

Additionally, in accordance with still another aspect of the present invention, there is provided a system for localizing defects causing leakage currents in a photovoltaic element, which comprises illuminating means for illuminating an area, having at least a minimum size, of the photovoltaic element, measurement means for measuring at least one photoinduced electrical value of an electrical potential between electrodes of the photovoltaic element at least one specific measurement position within the illuminated area on one of the electrodes of the photovoltaic element, and determining means for determining a position of a defect based on the measured at least one photoinduced electrical value and the at least one specific measurement position.

Preferably, the measurement means comprises at least one measuring contact for measuring the at least one photoinduced electrical value on one of the electrodes of the photovoltaic element. Additionally, in a preferred version of this embodiment the measurement means is further adapted to move the photovoltaic element in relation to the at least one measuring contact for measuring a number of photoinduced electrical values at different measurement positions e.g. at a speed of up to 15 m/min and to determine photoinduced electrical values at least every 50 µm.

Alternatively, the measurement means is further adapted to move the at least one measuring contact in relation to the photovoltaic element to the at least one specific measurement position on the electrode for measuring photoinduced electrical values.

Moreover, the measurement means is further adapted to store the measured at least one photoinduced electrical value in correlation with the at least one specific measurement position.

Additionally, the determining means further comprises voltage profile determining means for determining a position dependent voltage profile for an electrical potential based on the measured at least one photoinduced electrical value and the corresponding at least one specific measurement position, and minimum determining means for determining a minimum or maximum of the position dependent voltage profile and providing a position of the determined minimum or maximum as a position of the defect. Preferably, the minimum determining means is further adapted to calculate the differential values of the measured photoinduced electrical values by determining the difference between a first measured photoinduced electrical value and a second measured photoinduced electrical value preceding the first measured photoinduced electrical value. The measurement means comprises two measuring contacts spaced apart from each other are used for measuring photoinduced electrical values, the measurement means is adapted to store the measured photoinduced electrical values separately in correlation with the specific measurement positions for each of the measuring contacts, the voltage profile determining means is further adapted to separately determine position dependent voltage profiles based on a number of measured photoinduced electrical values and corresponding specific measurement positions for each of the measuring contacts, and the minimum determining means is further adapted to separately determine the minimum or maximum of each of the position dependent voltage profiles based on calculated differential values of the measured photoinduced electrical values and the corresponding specific measurement positions for each of the measuring contacts. Furthermore, the minimum determining means is further adapted to separately calculate the differential values of the measured photoinduced electrical values for each of the measuring contacts by determining the difference between a first measured photoinduced electrical value and a second measured photoinduced electrical value preceding the first measured photoinduced electrical value.

Preferably, the system further comprises passivating means for passivating the defect for which the position has been determined, wherein the passivating means comprises removing means for removing at least one of the electrodes in an area at the determined position of the defect. the removing means is adapted to locally remove a TCO layer used as an electrode via chemical etching or laser etching, wherein the determining means is further adapted to identify two or more defects for which the positions have been determined and which positions are next to each other as a cluster of defects and wherein the removing means is further adapted to draw the line with the specific width around the cluster of defects via laser etching. The removing means is further adapted to perform laser etching and to draw a line with a specific width around each of determined defects via laser etching and to remove the TCO layer along the line thereby ensuring that the TCO layer in electrical contact with the defects for which the positions have been determined has no electrical contact to the remaining TCO layer used as an electrode.

Preferably, the photovoltaic element is a roll-to-roll thin film solar cell, wherein the illuminating means is adapted to illuminate the photovoltaic element at an area, having at least a minimum size, of at least 1x1 cm².

Additionally, in accordance with yet another aspect of the present invention there is provided a system for localizing defects causing leakage currents in a photovoltaic element. The system comprises a light source arranged to illuminate an area, having at least a minimum size, of the photovoltaic element, a voltage detection unit arranged to measure photoinduced electrical values of an electrical potential between electrodes of the photovoltaic element at specific measurement positions within the illuminated area on one of the electrodes of the photovoltaic element, and a position determining unit arranged to determine a position of a defect based on the measured photoinduced electrical values and the specific measurement positions.

Moreover, in accordance with still another aspect of the present invention there is provided a system for passivating defects causing leakage currents in a photovoltaic element. The system comprises illuminating means for illuminating an area, having at least a minimum size, of the photovoltaic element, determining means for determining a position of a defect based on at least one photoinduced electrical value of an electrical potential between electrodes and a corresponding measurement position within the illuminated area on one of the electrodes of the photovoltaic element, and removing means for removing at least one of the electrodes in an area at the determined position of the defect via etching.

Preferably, the removing means are laser etching means. The laser etching means are adapted to remove the at least one of the electrodes in an area at the determined position of the defect along a line with a predetermined width by a laser thereby electrically isolating the defect.

Alternatively, the etching is performed via chemical etching, wherein the chemical etching is performed via pad printing and/or via jet printing.

Furthermore, in accordance with yet another aspect of the present invention there is provided a system for passivating defects causing leakage currents in a photovoltaic element. The system comprises a light source arranged to illuminate an area, having at least a minimum size, of the photovoltaic element, a position determining unit arranged to determine a position of a defect based on at least one photoinduced electrical value of an electrical potential between electrodes and a corresponding measurement position within the illuminated area, having at least a minimum size on one of the electrodes of the photovoltaic element, and an etching unit arranged to remove the electrode around the determined position of the defect.

Moreover, in accordance with still another aspect of the present invention there is provided a method for localizing defects causing leakage currents in a photovoltaic element comprising illuminating a specific area of the photovoltaic element, measuring at least one electrical value of an electrical potential between electrodes of the photovoltaic element and at least one specific measurement position within the illuminated specific area on one of the electrodes of the photovoltaic element and determining the position of the defect, based on the measured at least one voltage value and at least one specific measurement position.

Additionally, accordance with still another aspect of the present invention there is provided a system for passivating a shunt in a roll-to-roll photovoltaic element including a TCO layer as a front electrode. the system comprises determining means for determining a position of a shunt in the photovoltaic element, positioning means for positioning the photovoltaic element at the determined position, and removing means for removing the TCO layer in an area at the determined position of the shunt via etching thereby ensuring that the shunt has no electrical contact to the front electrode after removing the TCO layer.

Preferably, the removing means are further adapted to only partially remove the TCO layer around the shunt.

### BRIEF DESCRIPTION OF THE DRAWINGS

- Fig. 1: shows a schematic view of a baseline for a CISCuT Tape Cell Production.
- Fig. 2: shows a block diagram of a preferred embodiment of the present invention.
- Fig. 3: shows J/V curves of a preferred embodiment of the present invention.
- Fig. 4: is schematically illustrating the system for locating and passivating defects in a photovoltaic element according to a preferred embodiment of the present invention.
- Fig. 5: is a schematic diagram showing the measured electrical potentials next to a shunt measured with two measurement contacts according to the preferred embodiment of the present invention.
- Fig. 6: is another schematic diagram showing the measured electrical potentials of Fig. 5 measured with two measurement contacts and the derivatives thereof according to the preferred embodiment of the present invention.
- Fig. 7: is another schematic diagram showing the measured electrical potentials of Fig. 5 wherein a shunt position has been marked in accordance with the preferred embodiment of the present invention.
- Fig. 8: is another schematic diagram showing the measured electrical potentials of Fig. 5 with unfiltered derivatives thereof according to the preferred embodiment of the present invention.
- Fig. 9: shows a schematic diagram of the measured electrical potentials in the area of non-shunt structures according to the preferred embodiment of the present invention.
- Fig. 10: shows a schematic diagram of the measured electrical potentials in the area of a double shunt together with the derivative thereof according to the preferred embodiment of the present invention.
- Fig. 11a: is a schematic, cross-sectional view of the photovoltaic element with a determined shunt position according to a preferred embodiment of the present invention.
- Fig. 11b: is a schematic, cross-sectional view of the photovoltaic element shown in Fig. 11a wherein the shunt has been passivated according to a preferred embodiment of the present invention.
- Fig. 11c: is a schematic top view of the photovoltaic element shown in Fig. 11b.
- Fig. 12a: shows the movement of the laser spot in a fixed frame of reference according to another alternative to the preferred embodiment of the present invention.
- Fig. 12b: schematically shows the resulting trace of the laser spot on the top electrode of the photovoltaic element resulting from the movement as shown in Fig. 12a.
- Fig. 13: is a schematic view of the photovoltaic element with a passivated shunt in accordance with another alternative to the preferred embodiment of the present invention.
- Fig. 14a: shows a schematic cross-section of the photovoltaic element shown in Fig. 13.
- Fig. 14b: shows a schematic cross-section of two connected photovoltaic elements as shown in Fig. 14a in accordance with another alternative to the preferred embodiment of the present invention.
- Fig. 15a: shows a schematic cross-section of the photovoltaic element as shown in Fig. 13 wherein the cross-section is in an area of a passivated shunt.
- Fig. 15b: shows a schematic cross-section of two connected photovoltaic elements as shown in Fig. 15a in accordance with another alternative to the preferred embodiment of the present invention.
- Fig. 16: shows two strings composed by the cells of a photovoltaic element in accordance with another alternative to the preferred embodiment of the present invention.
- Fig. 17: is a flow chart for explaining the method for localising defects in a photovoltaic element in accordance with a preferred embodiment of the present invention.
- Fig. 18: is a flow chart for explaining the method for passivating defects in a photovoltaic element in accordance with a another preferred embodiment of the present invention.

### DETAILED DESCRIPTION OF THE INVENTION

A preferred embodiment of the present invention and alternatives thereof will be described herein below with reference to the accompanying drawings. In the following description, well-known functions or constructions are not described in detail since they would obscure the invention in unnecessary detail.

### 1. Shunt Detection

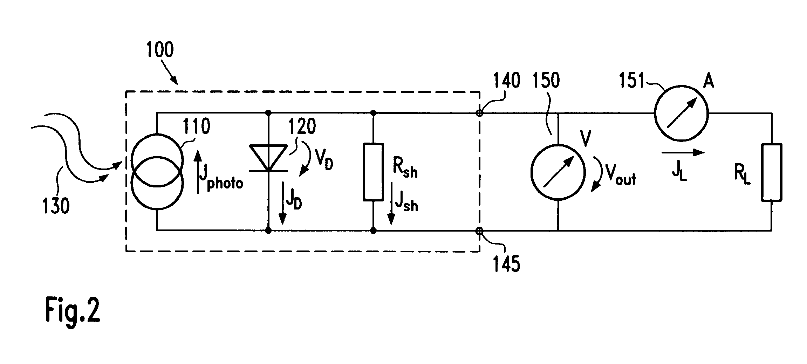

Fig. 2 is an equivalent circuit diagram showing a photovoltaic element and an equipment for localising a shunt in a photovoltaic element in accordance with an preferred embodiment of the present invention.

Fig. 2 shows a solar cell designated at reference numeral 100 wherein the solar cell is composed by equivalent components such as a current source 110, a diode 120 and a shunt resistant Rₛₕ. The diode 120 and the shunt resistant Rₛₕ are connected in parallel to the current source 110. Additionally a load resistant R_{L} is connected to the electrodes of the solar cell. Parallel to a load resistant R_{L} a voltage detection unit 150 is connected. Furthermore, in series to the load resistant R_{L} a current detection unit 151 is connected.

The current source 110 represents the generated current Jₚₕₒₜₒ when the solar cell is illuminated. The shunt resistant Rₛₕ represents the defects in the photovoltaic elements which cause a leakage current between the electrodes or within the photovoltaic elements. These defects are also called as shunts.

When the photovoltaic element 100 is illuminated by a light source 130 a specific current per area Jₚₕₒₜₒ also called current density is generated by the current source 110. In the case that the shunt resistant Rₛₕ is infinite current Jₚₕₒₜₒ can flow over diode 120 and load resistant R_{L}. The output voltage Vₒᵤₜ is measured by the voltage detection unit 150 via the electrodes of the solar cell. Load current J_{L} flowing over the load resistant R_{L} is measured via current detection unit 151.

In the case of a typical load resistant R_{L} the load current J_{L} is always smaller than the generated photo current Jₚₕₒₜₒ.

In the case that the load resistant R_{L} is zero (short circuit) the output voltage Vₒᵤₜ is also zero. Independently of the shunt resistance Rₛₕ >0 the load current J_{L} is equal to the generated photo current Jₚₕₒₜₒ (J_{L} = Jₚₕₒₜₒ). This current is called short circuit current J_{sc}.

In the case that the load resistant R_{L} and the shunt resistance Rₛₕ are infinite, the output voltage Vₒᵤₜ is limited to the diode voltage V_{D}. This voltage is called open circuit voltage Voc.

In the case that the load resistant R_{L} is infinite and the shunt resistance Rₛₕ has a typical value, part of the generated photo current Jₚₕₒₜₒ flows over the shunt resistance Rₛₕ. The diode voltage V_{D} gains its maximum value. That is the output voltage Vₒᵤₜ is dependent on the value of the shunt resistance Rₛₕ (Vₒᵤₜ < Voc).

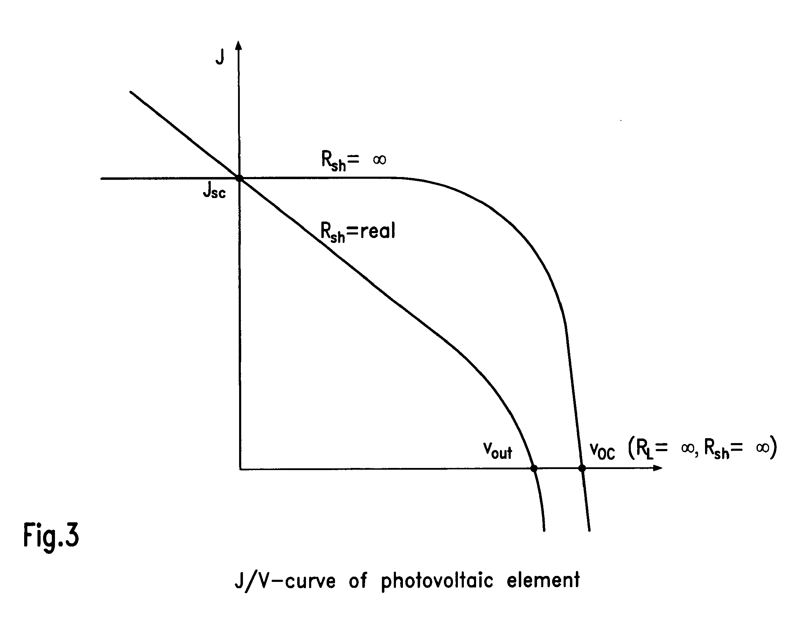

Fig. 3 shows J/V curves of a solar cell of a preferred embodiment of the present invention with the above specified cases Rₛₕ and R_{L}.

Generally the solar cell has a specific dimension and one or both of the electrodes 140 and 145 are made of materials which show a specific electric conductivity. Furthermore, the defects which cause the leakage current are limited to particular small areas of the photovoltaic element. Thus the output voltage Vₒᵤₜ measured at the load resistance R_{L} depends on how close to the shunt the measurement is performed. The closer to the shunt the measurement is performed, the lower is the output voltage Vₒᵤₜ. That means that a constant illumination of the photovoltaic element the output voltage Vₒᵤₜ varies in the presence of shunts in accordance with the measurement position in relation to the position of the shunts.

This effect is used in order to locate the position of a shunt in a photovoltaic element. This effect can be applied to thick-film or thin-film silicon based solar cells, III-V based solar cells, II-VI or I-III-VI based solar cells or above-mentioned CISCuT solar cells. Preferably this effect can be used for localising and subsequent passivating of roll-to-roll photovoltaic elements in particular for roll-to-roll CISCuT solar cells. These roll-to-roll photovoltaic elements are obtained by a roll-to-roll process. This is described in more detail in the following:

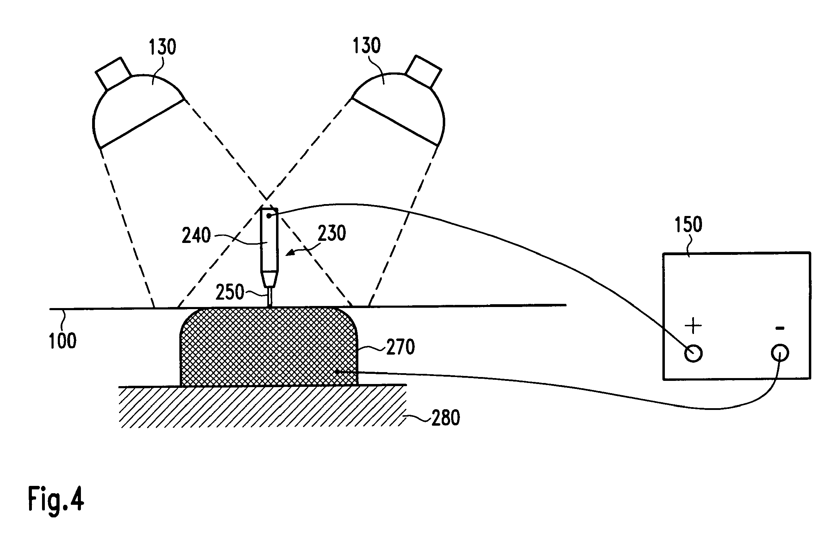

Fig. 4 shows the components for locating defects causing leakage current in a photovoltaic element according to the preferred embodiment of the present invention. Fig. 4 shows a light source 130 for illuminating an area, having at least a minimum size, of the photovoltaic element. Fig. 4 additionally shows measurement contact 230 and another contact 270 for measuring an electrical value and in particular the photoinduced electrical value of the electrical potential between electrodes 140 and 145. Preferably, the measurement contact 230 is used for measuring a respective photoinduced electrical value e.g. a voltage value on the front electrode and the other electrode 270 is used for contacting the photovoltaic element on the back electrode.

Preferably, the other contact 270 is a support for the photovoltaic element which is electrically conductive. In a particular preferred embodiment the photovoltaic element is a CISCuT roll-to-roll solar cell and the support 270 is a graphite block contacting the back electrode made of copper of the CISCuT roll-to-roll solar cell. Alternatively, the CISCuT roll-to-roll solar cell is not electrically contacted via the other contact 270 but is electrically contacted e.g. at the end of the copper tape of the CISCuT roll-to-roll solar cell. This alternative approach is also possible for reliably contacting the back electrode of the CISCuT roll-to-roll solar cell as the copper tape provides a good electrical conductivity.

Reference numeral indicates a platform to on which the other contact 270 is mounted.

Measurement contact 230 and the other contact 270 are connected to voltage detection unit 150 which preferably includes the load resistant R_{L}. Preferably, the load resistance is as high as possible, in order to measure the open-circuit voltage of the photovoltaic element. However, also a low load resistance R_{L} may be used.

According to the present invention the photovoltaic element is illuminated at an area, having at least a minimum size, which is preferably 1x1 cm². But for particular detailed measurements it might be that the area to be illuminated will be either reduced or increased in accordance with the measurement resolution to be achieved. Generally, a specific minimum area of the photovoltaic element should be illuminated. The higher the conductibility of the front electrode of the photovoltaic element is the larger should be the illuminated area of the photovoltaic element. The illuminated area has to be large enough so that the area of the measurement position are constant illuminated. This will be the minimum of illuminated area, any larger illuminated area don not influence the measurement of the present invention. In other words, up to a minimum of illuminated area the shunt determination is independent from the area which will be illuminated.

Accordingly, an alternative embodiment of the present invention includes the variation of the illuminated area of the photovoltaic element in accordance with the conductibility of the front electrode of the photovoltaic element.

Caused by the illumination of the photovoltaic element, an electrical potential between the electrodes 140 and 145 of the photovoltaic element can be detected. The detected voltage not only varies with the intensity of light and the frequency or colour spectrum of the illumination, but also varies in dependence with the measurement position in relation to a shunt position. In the case that the illumination of the solar cell is kept constant the measured voltage between the front electrode 140 and the back electrode 145 depends on whether there is a shunt in the solar cell and how close to the shunt position the measurement of the electrical potential between the front electrode 140 and the back electrode 145 is performed. By moving measurement contact 230 in relation to the shunt position the voltage measured by voltage measuring unit 150 varies. In the case that the at least one measurement contact is moved the light source 130 is also moved in connection with the measuring contact in order to provide the illumination of the measurement area.

Preferably, the photovoltaic element is arranged in a way so that the top surface of the photovoltaic element is faced upwards and the back electrode or back contact is faced downwards in regard to the light source 130. Accordingly the measurement contact 230 is positioned accordingly in order to contact the top surface of the photovoltaic element properly. Alternatively, the top surface of the photovoltaic element is oriented sidewards or downwards for the measurement. In that case, the light source 130, the measurement contact 230 and the other contact 270 are arranged correspondingly.

Alternatively and preferably the measuring contact 230, the other contact 270 and the light source 130 are stationary and the photovoltaic element is moved in relation to the contacts 230 and 270 and the light source 130. This is in particular advantageous, if the photovoltaic element is a roll-to-roll photovoltaic element.

In particular for a CISCuT roll-to-roll solar cell contact 270, preferably made by graphite or copper provides a good electrical contact to the back electrode of the CISCuT solar cell which is made by copper. This offers a possibility that the roll-to-roll solar cell is easily moved over the contact 270. Additionally, such a graphite contact provides a reliable electrical contact with the voltage measurement unit 150.

The measurement contact 230 is supported in a way so that a reliable electrical contact is provided at the front electrode and the photovoltaic element still can be moved easily under the measurement contact 230. For this the measurement contact can be spring-mounted whereas the spring force is adjusted in a way that the front electrode of the photovoltaic element is not damaged by the measurement contact 230. An adequate support of the measurement contact 230 provides that the electrical and mechanical contact of measurement contact 230 to the photovoltaic element 100 is lost due to the movement of the photovoltaic element 100.

The tip 250 of the measurement contact 230 is preferably a small needle which provides a good electrical contact to the front electrode, but does not electrically damage the front electrode. Alternatively, a round tip is used.

Preferably the roll-to-roll solar cell has a width of 10 mm and is several thousand metres long. The photovoltaic element may be moved as a fixed or variable speed. Preferably the solar cell is moved at a speed of up to 15 metres per minute. In that case preferably at least every 100 µm a photoinduced electrical value is measured by the voltage detection unit 150 when the photovoltaic element is moved in relation to the contacts 230 and 270.

Furthermore, detection units are used (which are not shown in fig. 4) which detect the measurement position of measurement contact 230 in relation to a specific position on one of the electrodes of the photovoltaic element. Preferably this specific position, the so called reference point, is the beginning of a roll-to-roll solar cell. In that way photoinduced electrical values can be measured over the whole length of the photovoltaic element in relation to the detected measurement position. By storing the photoinduced electrical values in relation to the detected measurement positions the position of a shunt can be determined based on the measured photoinduced electrical values and the specific detected measurement positions.

In a preferred alternative the measurement position is measured by a wheel which is in contact to the moved photovoltaic element. The wheel is connected to an incremental encoder which generates preferably 2,500 impulses per turn of the wheel. In the case that the wheel has a diameter of 100 mm this means that about every 125 µm one measurement cycle is performed. In an alternative version to the preferred embodiment the measurement resolution is increased below 100 µm and a wheel with a different diameter is used. The detected measurement position either might be recorded or stored as a measurement cycle in time units based on the known and constant velocity with which the photovoltaic element is moved. Alternatively, the detected measurement positions may be recorded or stored in units of micrometer or meter.

Fig. 4 shows only one measurement contact. This measurement contact is preferably positioned in the middle of the width of the photovoltaic element in particular. If the photovoltaic element is a roll-to-roll photovoltaic element with a width of e.g. 10 mm, the measurement contact 230 is positioned right in the middle of the roll-to-roll photovoltaic element in order to reliably detect the positions of the shunts. Alternatively two or more contacts may be used for detecting the shunts. In the case that two or more measurement contacts 230 are used for the detecting shunt positions, the measurement contacts are arranged in parallel in order to measure at the same measurement position in relation to the reference point of the roll-to-roll photovoltaic element. Alternatively, the two or more measurement contacts 230 may have well defined, known positions to each other and to the reference point which are taken into account when determining the position of a shunt. In the case that a roll-to-roll photovoltaic element with a width of 10 mm is measured preferably two measurement contacts 230 are used which are spaced apart about 3 mm.

As the effect of the measured photoinduced electrical values also varies in accordance with the intensity of the illumination the intensity of the illumination is adjusted to a level at which the shunt detection is most efficient. Accordingly, in an alternative preferred embodiment of the present invention the photovoltaic element is illuminated at a specific intensity and/or a specific wave length. This intensity and wave length either might be adjusted in a fixed way or automatically in accordance with the photovoltaic element to be measured. Alternatively, the intensity of the illumination is measured in correlation with the measurement position and the measured photoinduced electrical values. These measured illumination values are taken into account when determining the position of a shunt according to the alternative preferred embodiment of the present invention.

Preferably, a uniform illumination of the measurement area is provided for the measurement. Alternatively, an illumination of the measurement area may be chosen which may be varied over space and/or time. The variation of the illumination also may be measured and recorded during the measurement and taken into account when determining the position of a shunt according to the alternative preferred embodiment of the present invention.

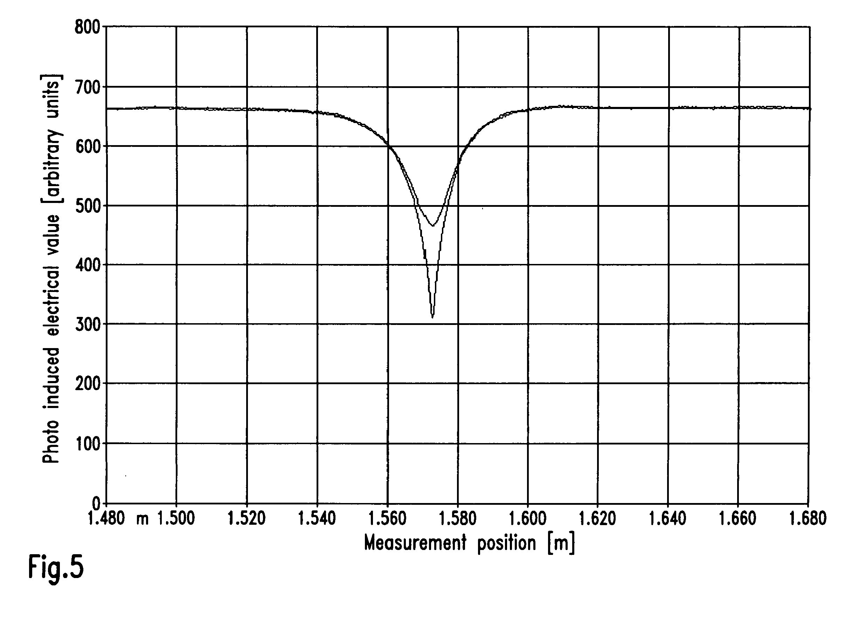

Fig. 5 is a schematic diagram showing the measured electrical potential next to a shunt according to the preferred embodiment of the present invention. The horizontal axis shows the detected measurement position and the vertical axis shows the detected voltage in arbitrary units. The diagram shows two graphs. The one graph shows a voltage profile measured by a first measurement contact 230 and the other graph shows a voltage profile measured by a second measurement contact 230. For each measurement position a respective photoinduced electrical value has been measured by the voltage detection unit 150, via one of the two measurement contacts.

The graphs, shown in Fig. 5 result from a preferred embodiment as shown in Fig. 4. For measuring the photoinduced electrical value profiles shown by the graphs the photovoltaic element has been illuminated at an area, having at least a minimum size of 1x1 cm² and the photoinduced electrical value has been measured by the two measurement contacts 230 and the other contact 270. Both measurement contacts 230 had the same measurement position in respect to the reference point of the photovoltaic element, but have been spaced e.g. 2.5 mm apart from the edge of the photovoltaic element. The photovoltaic element was moved at a specific constant speed in relation to the measurement contacts 230 and 270 and the light source 130. As the shunt passed the measurement contacts 230 at about position 1.570 m, the measured voltage at both contacts dropped to a specific minimum for each of the measurement contacts.

Preferably the shunt position is detected by analyzing the voltage profiles in relation the measurement position both recorded using measurement contacts 230 and 270 and the detection unit for detecting the measurement position. A preferred possibility for analyzing the voltage profiles is the minimum detection. Alternatively, a maximum detection can by used for analyzing the voltage profiles. This can be dependent on the polarity of the measured voltage profiles.

On the front electrode of a typical roll-to-roll photovoltaic element additional structures might be applied which are electrically isolating or are electrically isolated in regard to the back electrode. During the measurement of the photoinduced electrical values these additional structures might cause the effect that the measured photoinduced electrical values are zero or correspond to an undefined potential. Furthermore, during the measurement of the photoinduced electrical values it might be that also there is no physical contact between the front electrode 140 and the measurement contact 230. Thus, no well defined photoinduced electrical values can be detected by the voltage detection unit 150 as the measurement contact 230.

However, only shunts should be passivated. Therefore, above mentioned effects have to be clearly reliably distinguished from the effects caused by shunts when the recorded voltage profiles are analyzed.

One possibility of analyzing the determined voltage profiles is to determine the derivate of such a profile. Another possibility could be to analyze the determined voltage profile based on pattern recognition. For such a pattern recognition either the shape of the profiles is analyzed or specific functions are fit into the detected voltage profiles.

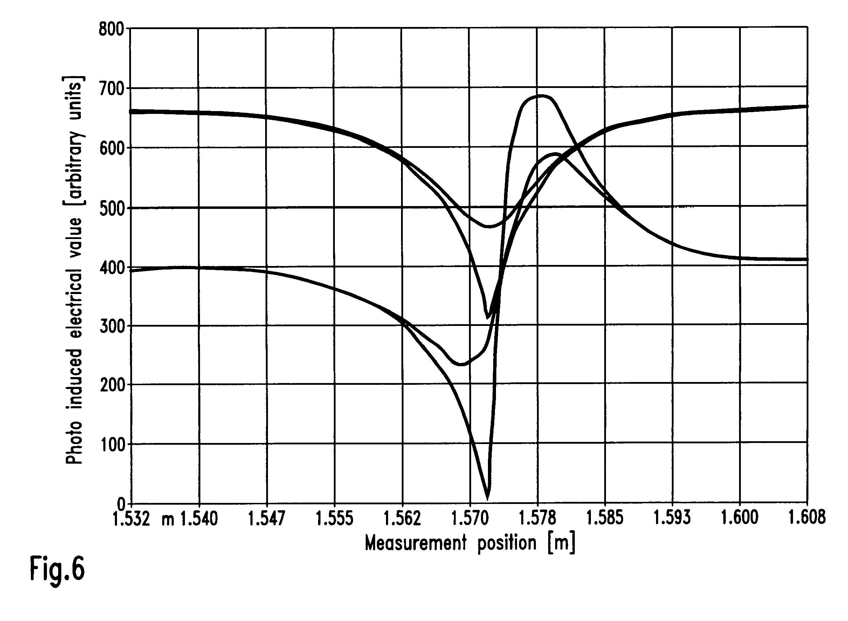

Fig. 6 is another schematic diagram of the measured electrical potentials shown in Fig. 5 additionally showing the respective derivative thereof. The diagram shown in Fig. 6 indicates on the horizontal axis the respective measurement position. The vertical axis is the measured voltage in arbitrary units. In regard to Fig. 5 the horizontal axis of Fig. 6 has been expanded around the measurement position 1.570 m. The upper two graphs represent the photoinduced electrical value measured at the two measurement contacts 230.

The lower two graphs represent the derivatives of the afore-mentioned voltage profiles. The derivatives are preferably determined by subtracting a previous photoinduced electrical value from the subsequent photoinduced electrical value. The thus created differential values may be averaged by a sliding averaging function which also might include weighing factors.

The graphs for the derivatives shown in fig. 6 have been averaged by a sliding average function.

Once the derivative for each of the voltage profile of the respective measurement contact has been determined each of the derivatives can be analyzed in order to determine the exact position of the shunt. For this each of the voltage profiles measured for one measurement contact 230 can be analyzed independent from the other voltage profile measured by the other measurement contact. The results of the separate analysis might be averaged or weighted in accordance with the achieved result. Alternatively, the voltage profiles obtained for the measurement contacts 230 are analyzed in a combined analysis wherein the results obtained for the different measurement contacts are combined simultaneously.

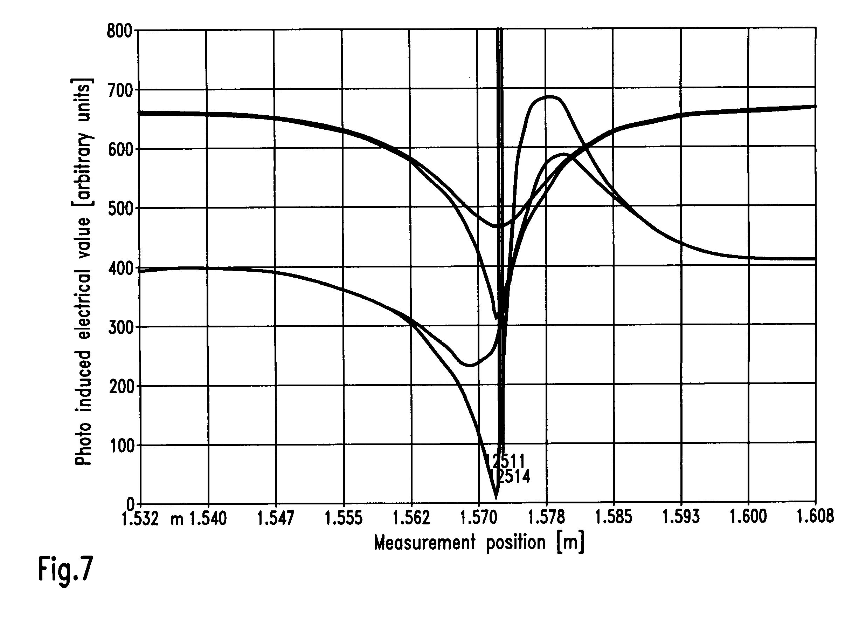

Fig. 7 shows another schematic diagram of the measured electrical potentials shown in Fig. 5 wherein a shunt position has been marked in accordance with the preferred embodiment of the present invention. The derivatives of the measured voltage profiles already explained in regard to Fig. 6 have been used in order to determine the shunt position. For each of the determined derivates a respective shunt position has been calculated. The respective shunt positions are marked by vertical lines around position 1.573.

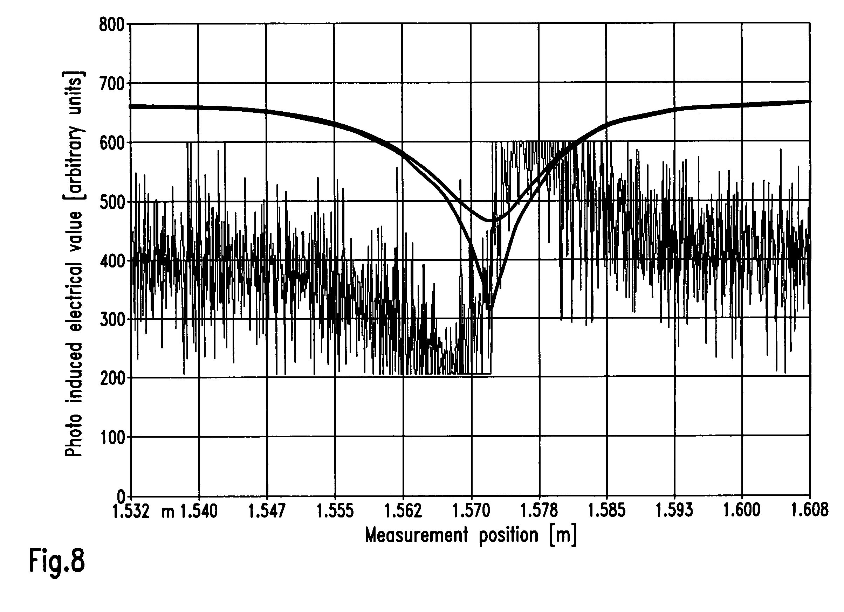

Fig. 8 shows another schematic diagram of the measured electrical potentials shown in Fig. 5 together with the respective derivatives thereof, according to an alternative of the preferred embodiment of the present invention. Contrary to the derivatives shown in Fig. 6 and Fig. 7, no averaging has been applied the differential values of the derivatives. Accordingly, the derivatives comprise significant noise. Nevertheless, it can be seen that even the not averaged values can be used for determining the minimum position of the voltage profiles measured by the voltage detection unit 150 in respect to each of the measurement contacts.

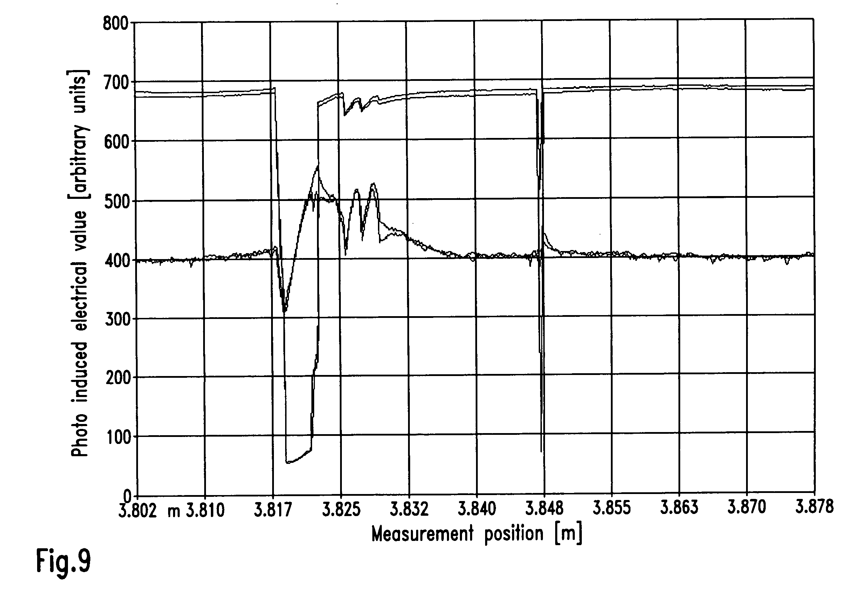

Fig. 9 shows a schematic diagram of the measured electrical potentials in the area of non-shunt structures according to the preferred embodiment of the present invention. As in Figs. 5 to 8 the horizontal axis shows the measurement position. The vertical axis shows the measured photoinduced electrical values in arbitrary units. Around position 3.820 and 3.847 both measurement contacts show a minimum in the voltage profile. However, the shape of the voltage profile is completely different from that shown in Figs. 5 to 8. Additionally, around position 3.827 an additional effect is shown. The lower two graphs represent the derivatives for the voltage profiles shown in Fig. 9. These derivatives also significantly differ from the derivatives determined for shunts. Based on these significant differences shunts and non-shunt effects can be distinguished by applying either above-mentioned minimum/maximum detection or pattern recognition.

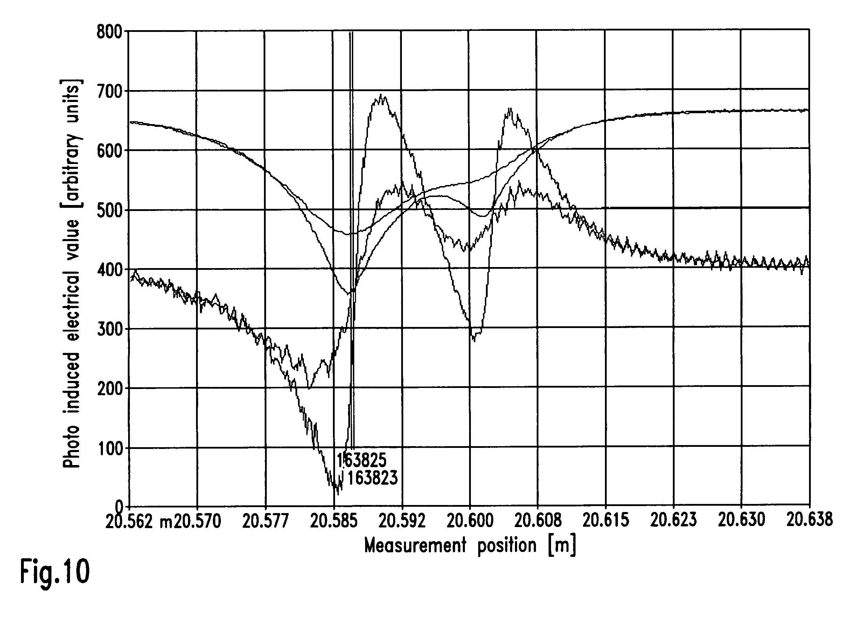

Fig. 10 shows a schematic diagram of the measured electrical potentials in the area of a double shunt together with the derivative thereof according to the preferred embodiment of the present invention. As for Figs. 5 to 9 the voltage profiles for two measurement contacts 230 as measured by voltage detection unit 150 are displayed in the upper graphs of Fig. 10. As it can be seen two shunts are detected which are positioned closely to each other. In the lower two graphs, the derivative of the respective voltage profiles are shown. For the shunt positioned around 20.588 the shunt position has been already marked. Alternatively, the shunt position of the closely positioned second shunt can also be marked in accordance with the preferred embodiment of the present invention based on the determined derivatives.

Preferably, the analysis of the measured voltage profiles is performed after all necessary photoinduced electrical values have been measured for the photovoltaic element. For a roll-to-roll photovoltaic element this means that the photoinduced electrical values are measured and recorded together with the respective measurement positions for the complete roll-to-roll photovoltaic element. For this the measured photoinduced electrical values for each of the measurement contacts 230 are stored together with the corresponding measurement positions in a stored unit. After that, in a subsequent step the measured data are analyzed and the shunt positions are determined as explained above. The determined shunt positions are stored.

Alternatively, the measurement of the voltage profile and the analysis of the voltage profile are performed simultaneously. In that case preferably only the detected shunt positions are stored in the storage unit.

As shown in Fig. 10 two or even more shunts may be spaced closely together. Therefore, information on the detected shunts has to be provided in a way, so that even a number of shunts positioned closely together can be reliably passivated.

In a preferred embodiment of the present invention the determined shunt positions are stored in different channels. Preferably ten pipelines are provided i.e. up to ten closely positioned shunts can be reliably passivated. For this, preferably a computer performs the analysis on the voltage profiles as mentioned above. The computer stores in respective channels information in relation to the distance to the reference point which informs in advance that a shunt will arrive within a specific distance. If there is information on an arriving detected shunt this information will be placed in channel 1. However, in the case of several closely positioned shunts channel 1 will already be occupied by information regarding the shunt next to the actual position. Accordingly, the information regarding the other shunts will be stored in the subsequent channels. In this way, by analyzing all channels, it can be easily detected whether only one or whether several closely positioned shunts are "on the way". In the case that no closely positioned shunt is "on the way" only a channel 1 is occupied by the respective information.

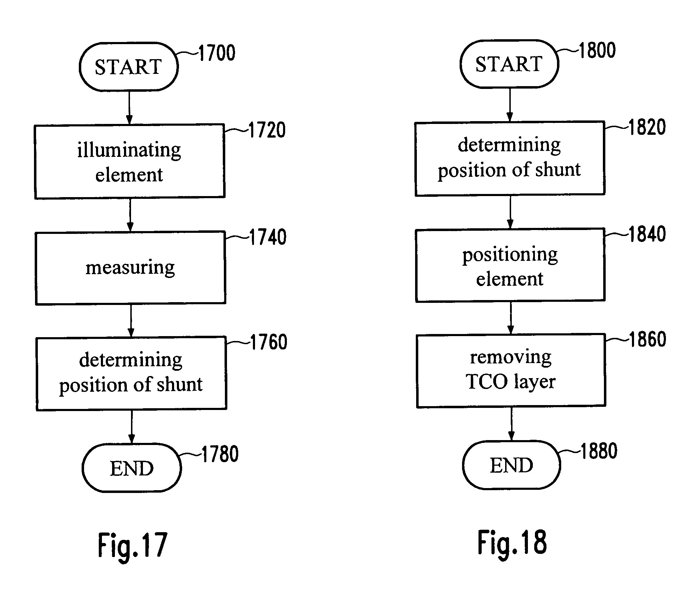

Fig. 17 is a flow chart for explaining the method for localizing defects in a photovoltaic element in accordance with a preferred embodiment of the present invention. This method comprises step 1720 of illuminating an area, having at least a minimum size, of the photovoltaic element. It further comprises step 1740 for measuring at least one electrical value of an electrical potential between electrodes of the photovoltaic element at at least one specific measurement position within the illuminated area, having at least a minimum size on one of the electrodes of the photovoltaic element. Moreover, it comprises the step 1760 for determining a position of a defect based on the measured at least one photoinduced electrical value and the at least one specific measurement position.

### 2. Shunt Passivation

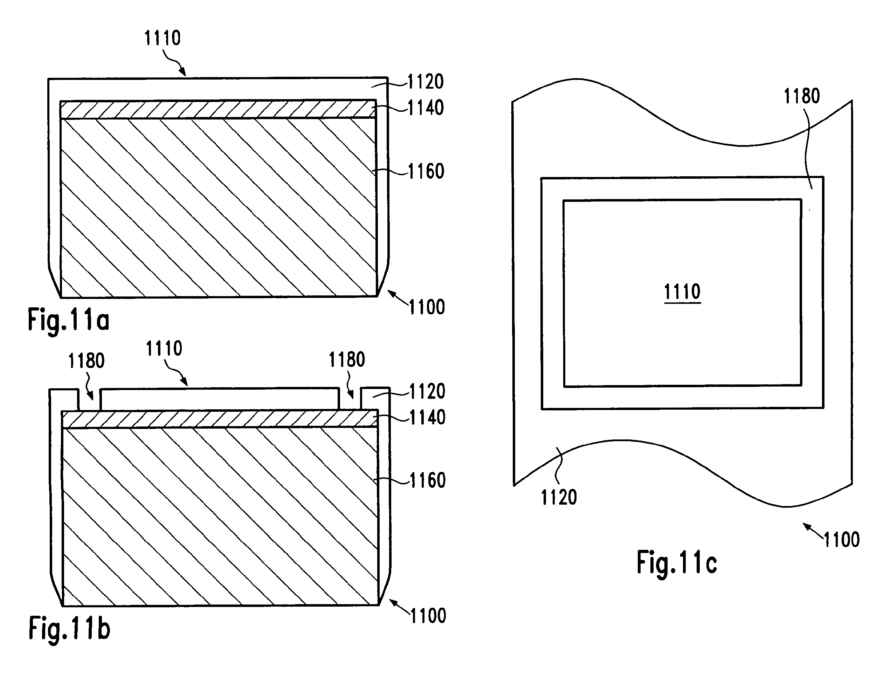

Fig. 11a is a schematic-cross sectional few of the photovoltaic element with a determined shunt position, according to a preferred embodiment of the present invention. The photovoltaic element is designated at referenced numeral 1100. Preferably of the photovoltaic element 1100 is a CISCuT solar cell composed by the copper tape 1160, the CIS absorber layer 1140 and the TCO layer 1120. Preferably, the copper tape 1160 forms the back electrode and the TCO layer 1120 the front electrode the CIS absorber layer 1140 has a high electrical resistivity and forms the photoactive diode including a p/n junction. This absorber layer 1140 can be also consist of two layers having different conductivity to form a diode, preferably a n-type CIS layer and a p-type CuI or CuS layer. However, also other combinations are possible like p-type CIS layer and n-type layer consisting of CdS, ZnS, ZnO or ZnO:Al. Further on it is to understand that CIS layer 1140 consists of one of these alternatives.

The dimensions shown in Fig. 11a are not true to scale. The height of the photovoltaic element is shown enlarged in comparison to the width of the photovoltaic element 1100. Preferably, a CISCuT solar cell has a width of 8 to 13 mm and a height of 0,05 to 0.3 mm. However, smaller or larger dimensions for the width or the height are possible.

As outlined above a CIS absorber layer 1140 is formed on the upper side of the copper tape. On this CIS absorber layer 1140 a TCO layer 1120 is formed which also extends to both sides of the photovoltaic elements.

In an alternative embodiment of the present invention not shown in Fig. 11a a isolating layer is positioned on either one side face or both side faces of the photovoltaic elements so that it electrically isolates the TCO layer 1120 on the side faces of the photovoltaic elements from the copper tape and the CIS absorber layer. In that way it is prevented that the copper tape has an electrical contact to the front electrode via the TCO layer at the side faces. Thus, a short circuit from the TCO layer 1120 to the copper tape 1160 is avoided.

As shown in Fig 11a a determined shunt position 1110 is indicated. In order to passivate such a punctual defect, which causes a leakage current between the front electrode 1120 and the back electrode 1160, the located defect 1110 has to be passivated in a way so that the leakage current caused by the defect 1110 is minimized or even eliminated. For this the front electrode formed by the TCO layer 1120 is removed around the located shunt 1110 either partially or complete.

Fig. 11b shows a schematic, cross-sectional view of the photovoltaic element as shown in Fig. 11a, wherein the TCO layer 1120 is removed in part around the located shunt 1110. Fig. 11b shows grooves 1180 in the TCO layer 1120 in which the TCO layer is completely removed. Accordingly, the remaining part of the TCO layer 1120 between the grooves has no electrical contact to the other part of the TCO layer. The width of the grooves 1180 depends on the electrical conductivity of the layer 1140. The preferable width of the grooves 1180 are in the range between 15 µm and 100 µm. As lower the conductivity of layer 1140 as lower the width of the grooves 1180 can be. In this way, the detected shunt 1120 is electrically isolated from the remaining photovoltaic elements. In such a way, the influence of the leakage current caused by the localised shunt 1110 to the remaining front electrode is eliminated.

Fig. 11c is a schematic top view of the photovoltaic elements shown in Fig. 11b, wherein the detected shunt 1110 has been passivated according to one alternative of the preferred embodiment of the present invention. As it can be seen in Fig. 11c, a line with a rectangular shape has been drawn around the located defect 1110. As this line is formed by a groove 1180 in which the TCO layer 1120 is completely removed the remaining TCO layer surrounded by the groove is electrically isolated from the TCO layer outside the rectangular shaped area. Alternatively, an area, having at least a minimum size surrounded by the groove can have any arbitrary shape. Furthermore, alternatively not only a small part of the TCO layer is be removed but the complete TCO layer within an area, having at lest a minimum size.

Preferably, the TCO layer 1120 is formed by a ZnO:Al or doped ZnO layer which can be either removed via chemical etching or via laser etching. The chemical etching preferably may be performed by pad printing or jet printing. In both cases either only a part of the TCO layer 1120 is removed as shown in Fig. 11c or the complete TCO layer is removed around the located shunt 1110.

Alternatively, the TCO layer 1120 is formed by an Indium Tin Oxide (ITO) layer (e.g. In₂O₃:SnO₂) or SnO₂:F layer.

Preferably the size of the rectangle surrounded by the groove 1180 is about 10 mm x 3 mm. However, depending on the size of the photovoltaic elements or on the number of detected shunts in an area, having at least a minimum size, smaller or larger structures may be used for passivating the located defect 1110.

Alternatively, the size of the TCO layer removed around the located shunt 1110 is varied in accordance with the accuracy achieved by determining the position of the shunt. This means that if the accuracy for the determined position of the shunt is high, less TCO layer is removed around the detected shunt 1110. In the case that the accuracy for the determined position of the shunt 1110 is lower, the area of the rectangle and thus the area of the removed TCO layer is larger.

As mentioned above, the TCO layer may be removed by processes such as chemical etching or laser etching. In particular laser etching appears to be suitable in regard to vary the size and shape of the area to be electrically isolated from the other part of the TCO layer 1120 in order to passivate the defect.

Preferably, the laser etching is performed by illuminating the TCO layer with laser light having a specific intensity. Such a process is also called laser scribing. Preferably, a Nd:YAG laser with a wavelength of 1064 nm may be used. However, any other suitable laser such as Nd:YLF or Ti:Sa can also be used. Preferably, the wavelength of the Nd:YAG laser is tripled so that the resulting wavelength is 355 nm. Alternatively, other wavelengths in the UV range such as 266 nm can be used. Generally, a wide wavelength range appears to be applicable depending of the electrode material which has to be processed. For specific TCOs this range can be between 200 nm and 380 nm, however depending on the TCO used wavelength in the infrared and visible range also may be used. Depending on the required wavelength also an excimer laser or diode lasers may be used for the laser scribing.

Furthermore, the laser used can be a continuous wave laser or a pulse laser.

The laser spot on the TCO layer and the laser energy is adjusted in order to remove the TCO-layer completely and to avoid melting the CIS absorber layer. Preferably, the laser spot on the TCO layer has a size or is varied between 15 µm and 100 µm. The pulse energy of a laser pulse applied to the TCO layer is also adjusted to the electrode material which has to be processed. For a ZnO:Al layer the pulse energy is preferably larger than 50 µJ and lower than 200 µJ.

In the case that the photovoltaic element is stationery during the passivating process the chemical etching and laser etching is preferably preformed stationary, too. Alternatively, in the case that a roll-to-roll photovoltaic element is used, the motion of the photovoltaic element is stopped during the passivating process.

In a further alternative the roll-to-roll photovoltaic element also moves during the passivating process. However, this means that the passivating means for chemical or laser etching have to move with the same speed as the photovoltaic element during the passivating process. For chemical etching which is e.g. performed by pad printing or jet printing this would mean that the motion of the etching unit is correlated with the motion of the roll-to-roll photovoltaic element.

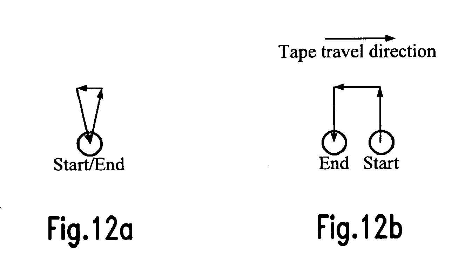

For laser etching, where the laser spot is scribing a groove on the roll-to-roll photovoltaic element, this would mean that the motion of the laser spot has to be coordinated with the movement of the roll-to-roll photovoltaic element, too. This is shown in Fig. 12a which shows the movement of the laser head or the laser spot in a fixed frame of reference in the case that one or two sides of the roll-to-roll photovoltaic element have been already passivated in a previous edge-passivating step. In such a case the laser spot will start at the edge-passivated side of the photovoltaic element and move with the travel direction of the roll-to-roll photovoltaic element from one side of the photovoltaic element to the other photovoltaic element. In a next step, the laser spot will move in the opposite direction of the travel direction of the roll-to-roll photovoltaic element. In order to close the rectangle the laser spot will return to the edge-passivated side by additionally following the travel direction of the roll-to-roll photovoltaic element.

Fig. 12b schematically shows the resulting trace of the laser spot on the top electrode of the photovoltaic element.

Starting from the already passivated edge on one side of the photovoltaic element, the rectangle will be completed by ending again on the already passivated edge of the photovoltaic element. This results in an area around a determined shunt position which is electrically isolated from the remaining front electrode. Thus the shunt is passivated.

In the case that one or both edges of the roll-to-roll photovoltaic element have not been treated by edge passivation, the passivating of the shunt will be finished by an movement of the laser spot in the travel direction in order to close the rectangle drawn by the laser spot.

Alternatively, the above-described movement of the laser spot may be performed in reverse direction.

It is clear for the skilled person that any shape for the passivated area can be chosen as long as the area around the shunt is electrically disconnected from the remaining front electrode.

Fig. 18 is a flow chart for explaining the method for passivating defects in a photovoltaic element in accordance with an alternative embodiment of the present invention. This method comprises step 1820 of determining a position of a shunt in the photovoltaic element and step 1840 of positioning the photovoltaic element at the determined position. Moreover, it comprises step 1860 of removing the TCO layer in an area at the determined position of the shunt via etching thereby ensuring that the shunt has no electrical contact to the front electrode after removing the TCO layer.

### 3. Isolation and Assembling

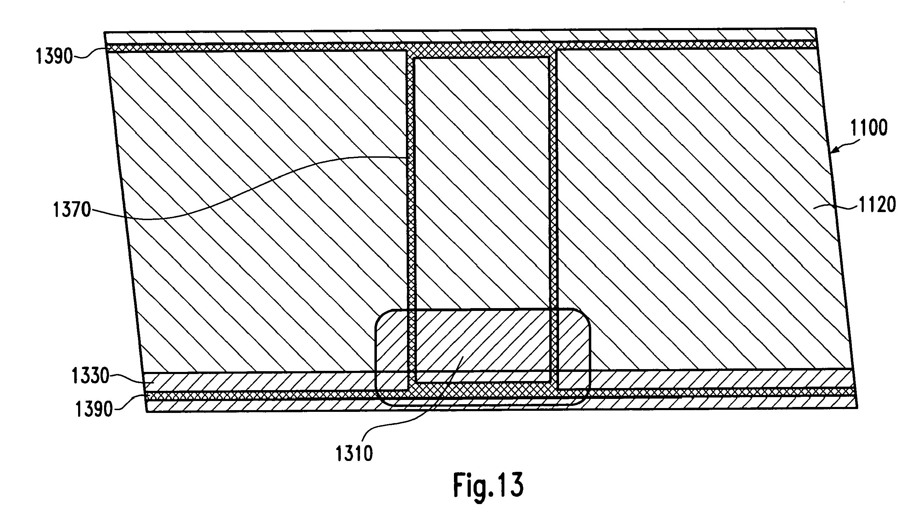

Fig. 13 is a schematic view of the photovoltaic element with a passivated shunt in accordance with one embodiment of the present invention. Preferably, the photovoltaic element 1100 is a roll-to-roll photovoltaic element which is shown from the top view. Accordingly, the front electrode 1120 can be seen together with grooves 1390 which extend along the side edges of the photovoltaic element. The grooves 1390 at the side edges of the photovoltaic element are either made by laser etching or by chemical etching. These grooves separate the TCO layer on the upper side of the photovoltaic element from the TCO layer at the side of a photovoltaic element as e.g. shown in Figs. 11a and b. These grooves prevent a short circuit from the top electrode to the back electrode. Furthermore, additional grooves 1370 are shown in Fig. 13, which passivate a detected shunt. As it can been seen in Fig. 13 alternatively to the passivation described in regard to Fig. 12a and Fig. 12b a complete rectangle has been formed around the determined shunt position by either by laser etching or chemical etching.

Additionally, along one edge of the photovoltaic element a narrow strip of electrically isolating material is provided. Preferably, this strip extends from one edge of the photovoltaic element over the groove placed next to that edge. The width of this strip of electrically isolating material may vary between a few 100 µm and 2 mm. The strip may have a uniform width or the width may vary depending on its position on the roll-to-roll photovoltaic element. Preferably, the electrically isolating material is resin, however, other electrically isolated materials may be used such as an insulating glassy layer of nanomere. The thickness of the strip depends on the material used but preferably varies from 500 nm to several 10 µm. These materials are applied preferably by pad printing or jet printing. However, these materials also may be applied in other ways on the photovoltaic element.

Strip 1330 is for providing an electrical isolation for the case that the photovoltaic element is mechanically connected to another photovoltaic element.

Furthermore, Fig. 13 shows another structure 1310 made of electrically isolating material which is located on one side of an area which is electrically passivated in view of a detected shunt.

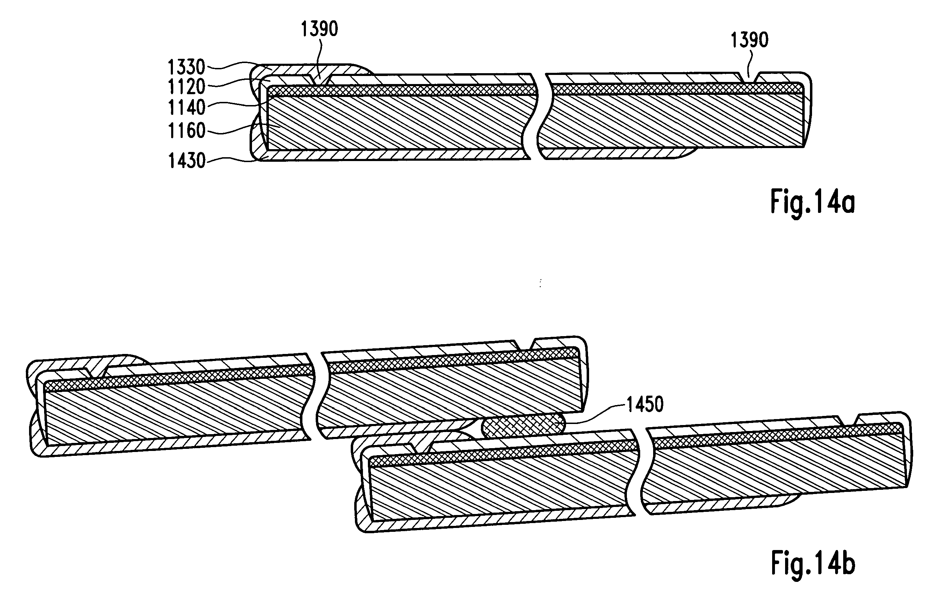

Fig. 14a shows a schematic cross section of the photovoltaic element shown in Fig. 13. As it can been seen the photovoltaic element additionally provides a further structure 1430 for electrically isolating the lower part of the photovoltaic element, at least in part. Thus a part of the back electrode is electrically isolated.

Fig. 14b shows in a cross-sectional view two connected photovoltaic elements shown in Fig. 14a. Two photovoltaic elements are assembled into a photovoltaic module. In view of the isolating structures 1490 and 1430 an undefined electrical contact between the upper and lower photovoltaic element is prevented. Defined electrical contact is provided through electrical conductive structure 1450 which is preferably a conductive glue. In that way it is established, that the back electrode of the upper photovoltaic element is connected in a defined way with the top electrode of the lower photovoltaic element.

The afore-mentioned way for mechanically and electrically connecting two photovoltaic elements can be used not only for connecting two but an arbitrary number of photovoltaic elements.

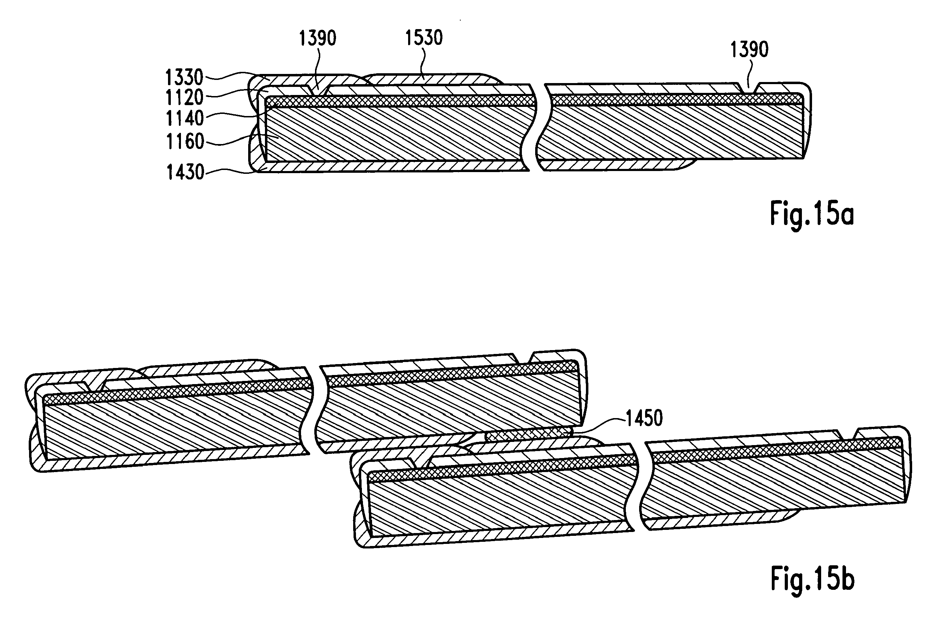

Fig. 15a shows a schematic cross-section of the photovoltaic element as shown in Fig. 13 wherein the cross-section is in an area of a passivated shunt. It shows the grooves 1390 electrically isolating the front electrode made by TCO layer from the remaining TCO layer at the edges of the photovoltaic elements. Furthermore, the back electrode 1160 and the structures 1490 and 1430 for electrically isolating part of the front electrode and the back electrode are shown. As shown in Fig. 13 an additional isolation 1410 is applied on the top side of the photovoltaic element at least on one part of the passivated area. This additional isolating structure is shown in fig. 15a by reference numeral 1530. Alternatively to an additional isolating structure 1530 the isolating structure 1330 may have broader width covering at least on one part of the passivated area.

As shown in Fig. 15b two photovoltaic elements are connected in a way as already explained in Fig. 14b. The difference between Fig. 15b and 14b is that Fig. 15b shows a cross-sectional view of two connected photovoltaic elements in area of a passivated shunt. As it can be seen from Fig. 15b both photovoltaic elements are connected by glue 1450 in order to mechanically connect the back electrode of the upper photovoltaic element with the front electrode of the lower photovoltaic element. However, in order to avoid an electrical contact with the passivated shunt area, the additional isolating structure 1530 provided in the area of the passivated shunt prevents that the glue 1450 is electrically connecting also the passivating shunt area to the back electrode of the other photovoltaic element. In that way it is avoided that the front electrode disconnected in the area of the detected shunt is reconnected by assembling two photovoltaic elements.

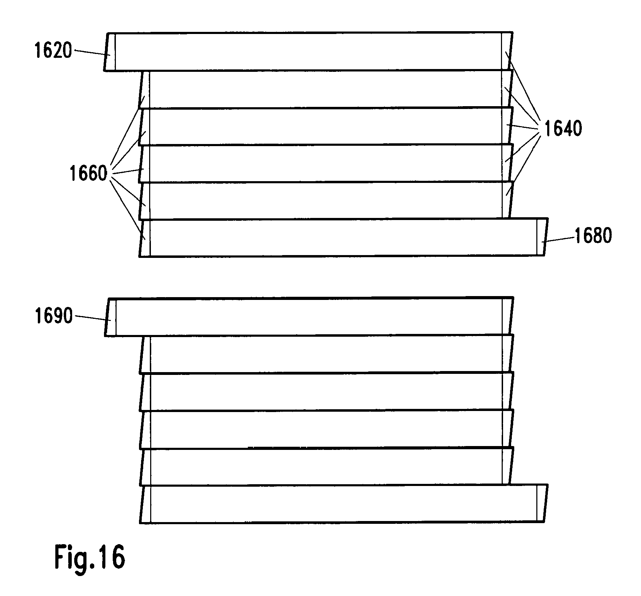

Fig. 16 shows two so called strings, each composed by six photovoltaic elements in accordance with an embodiment of the present invention. For both strings the first photovoltaic element and the last photovoltaic element are longer than the other four photovoltaic elements. The first photovoltaic element extends on the one side of the string and the last photovoltaic element extends on the other side of the string. The first photovoltaic element extends on one side in order to be interconnected by a bus bar on the front electrode with the first photovoltaic element of another string. The last photovoltaic element of this string extends on the other side in order to be interconnected by another bus bar on the back electrode with the last photovoltaic element of another string.

Alternatively, the strings consist not only by six photovoltaic elements, but any number of photovoltaic element desired. Furthermore, the last electrode is interconnected alternatively on the front electrode and the first electrode is alternatively interconnected on the back electrode. Additionally, not only two strings may be interconnected but any desired number of strings.

As either the first or the last of the six photovoltaic elements is only used for connecting either the front or the back electrode only five photovoltaic elements are active, i.e. contribute to the generated current. In the case that N photovoltaic elements are connected only N-1 photovoltaic elements are active.

In that case the first photovoltaic element extends on one side in order to be interconnected by a bus bar on the back electrode with the back electrode of first photovoltaic element of another string. The last photovoltaic element of this string extends on the other side in order to be interconnected by another bus bar on the back electrode with back electrode of the last photovoltaic element of another string.

Alternatively the first photovoltaic element extends on one side in order to be interconnected by a bus bar on the front electrode with the front electrode of first photovoltaic element of another string. The last photovoltaic element of this string extends on the other side in order to be interconnected by another bus bar on the front electrode with front electrode of the last photovoltaic element of another string.

Furthermore, Fig. 16 shows specific marks 1620, 1640, 1660, 1680 and 1690. These marks result from cutting the roll-to-roll photovoltaic element and to separate pieces of photovoltaic elements. In order to cut the roll-to-roll photovoltaic element at the desired positions needed for the production of the strings so called cutting marks are created on one of the electrodes of the roll-to-roll photovoltaic element. Preferably, the cutting marks are created on the front electrode of the photovoltaic element which is preferably a TCO layer.

Cutting the roll-to-roll photovoltaic element into separate photovoltaic elements causes that the structure of the photovoltaic element, i.e. the TCO layer, the CIS absorber and the back electrode is damaged in a way so that a short circuit between the TCO layer and the back electrode might be created.

The cutting marks according to one embodiment of the present invention are applied to the TCO layer in a way that they not only show and mark the position for cutting the roll-to-roll photovoltaic element but also to electrically disconnect the cut side of the photovoltaic element from the remaining part of the front electrode. This is performed in the same way as the edge-passivation and/or the shunt passivation.

Preferably, the cutting mark for indicating where the roll-to-roll photovoltaic element has to be cut has a similar shape as the structure for passivating the detected shunt. Preferably the marks/structures for passivating the detected shunt and for cutting the role-to-role photovoltaic element differ in its width. This means that e.g. a rectangular form is for passivating detected shunts and for indicating where the role-to-role photovoltaic element has to be cut. However, the width of the rectangular form used varies in accordance with its function to be used. For example the rectangle for passivating a detected shunt has a first specific width and the rectangle for indicating a cutting mark has a second specific width which differs from that for passivating a shunt.

Furthermore, as the first and the last photovoltaic element of a string are preferably longer than the other photovoltaic elements in the string the cutting marks for the first and the last photovoltaic element in a string may differ in width from that of a cutting mark for the second and other photovoltaic element in a string.

In that way it can be automatically detected whether there is an area of a passivated shunt, a cutting mark of a first, a second, a subsequent or a last photovoltaic element for a string.

The detection of the respective marks may be performed by the aforementioned method for detecting shunts. As e.g. shown in Fig. 9 different structures on the front electrode of the photovoltaic element can be detected by the aforementioned way of analysing the potential between the front electrode and the back electrode. As this method provides a spatial resolution it can distinguish between the different widths of the structures for the passivated shunt or the respective marks for cutting the photovoltaic element.

Therefore, the aforementioned method for detecting shunts also can be used for detecting a cell mark for cutting the photovoltaic element or a string mark for cutting the first or the last photovoltaic element of a string. The cell mark and the string mark may differ from each other in width or shape detectable by the aforementioned method for detecting shunts. By example the cell mark and the string mark may be formed as rectangles with different width. They also may be represented by double or triple lines with different distances from each others.

Additional also optical methods can be used for detecting cell marks. These methods can be measure the distance and/or numbers of the lines of a mark. Optical sensors or camera systems will be useful in order to detect the cell marks.

Above described cutting marks are shown in Fig. 16. Reference numeral 1620 shows the second half of the cutting mark for the first photovoltaic element of a string. Reference numeral 1640 shows the first half of the cutting mark for the subsequent photovoltaic elements and reference numeral 1660 shows the second half of the cutting mark for the subsequent photovoltaic element. Reference numeral 1680 shows the first half of the cutting mark for the last photovoltaic element which is in the embodiment shown in fig. 16 also the cutting mark for the first element of the next string. Reference numeral 1690 is the second half of the cutting mark of the last photovoltaic element of the previous string.

In order to avoid a short circuit between the electrodes of two subsequent photovoltaic elements in a string a similar isolating structure is applied to the front side of the photovoltaic element as shown in Fig. 13 for the passivated shunt area. By using a structure similar to 1310 of Fig. 13 or 1530 in Fig. 15a and b it is avoided that a short circuit between the front electrode and the back electrode at the cut side of a photovoltaic element also short-circuits the subsequent photovoltaic element. Accordingly, the electrically isolated cutting mark shows a similar structure as shown in Fig. 15a and 15b for passivated shunts.

The above described way for detecting and passivating shunts on a photovoltaic element and the way of connecting these photovoltaic elements offers a high degree of automation for manufacturing and assembling these photovoltaic elements. Furthermore, the above mentioned way of manufacturing photovoltaic modules offers the possibility for selectively passivating detected shunts in order to increase the efficiency of the manufactured photovoltaic modules. The way of passivating the detected shunts in the photovoltaic elements and interconnecting the photovoltaic elements with each other offers the possibility to manufacture photovoltaic modules in almost all desired sizes. This results in low price per m² and flexibility in shape and size. Furthermore, this offers a high cost reduction potential with low material consumption and an increased efficiency of the photovoltaic modules.

While the invention has been shown and described with reference to a certain preferred embodiment thereof, it will be understood by those skilled in the art that various changes in form and details may be made therein without departing from the spirit and scope of the invention as defined by the appended claims.

## Claims

1. Method for localizing defects causing leakage currents in a photovoltaic element comprising the steps of:
(i) illuminating an area, having at least a minimum size, of the photovoltaic element;
(ii) measuring at least one photoinduced electrical value by contacting two electrodes of the illuminated photovoltaic element at at least one specific measurement position within the illuminated area on one of the electrodes of the photovoltaic element; and
(iii) determining a position of a defect of the photovoltaic element, based on the measured at least one photoinduced electrical value and the at least one specific measurement position.

2. The method of claim 1, wherein in step (ii) the at least one electrical value is a photoinduced electrical value which is measured via at least one measuring contact on one of the electrodes of the photovoltaic element.

3. The method of claim 1 or 2, wherein in step (ii) the photovoltaic element is moved in relation to the at least one measuring contact for measuring a number of photoinduced electrical values at different measurement positions.

4. The method of any of claims 1 to 3, wherein the photovoltaic element is moved at a speed of up to 15 m/min and photoinduced electrical values are determined at least every 50 µm.

5. The method of any of claims 1 to 4, wherein step (iii) further comprises the substeps:
(iiia) determining a position dependent photoinduced electrical value profile based on the measured at least one photoinduced electrical value and the corresponding at least one specific measurement position; and
(iiib) determining a minimum or maximum of the position dependent photoinduced electrical value profile providing a position of the determined minimum or maximum as a position of the defect.

6. The method of claim 5, wherein the differential values of the measured photoinduced electrical values are calculated by determining the difference between a first measured photoinduced electrical value and a second measured photoinduced electrical value preceding the first measured photoinduced electrical value.

7. The method of claim 6, wherein two measuring contacts spaced apart from each other are used for measuring photoinduced electrical values, the measured photoinduced electrical values are separately stored in correlation with the specific measurement positions for each of the measuring contacts, position dependent voltage profiles are separately determined based on a number of measured photoinduced electrical values and corresponding specific measurement positions for each of the measuring contacts, and the minimum or maximum of each of the position dependent voltage profiles is separately determined based on calculated differential values of the measured photoinduced electrical values and the corresponding specific measurement positions for each of the measuring contacts.

8. The method of claim 7, wherein the differential values of the measured photoinduced electrical values are separately calculated for each of the measuring contacts by determining the difference between a first measured photoinduced electrical value and a second measured photoinduced electrical value preceding the first measured photoinduced electrical value.

9. The method of any of claims 1 to 8, further comprising following step:
(iv) electrically passivating the defect for which the position has been determined.

10. The method of claim 9, wherein step (iv) comprises removing at least one of the electrodes in an area around the determined position of the defect.

11. The method of claim 9 and 10, wherein one of the electrodes is a TCO layer and wherein the passivation of the determined defect is performed via locally removing the TCO layer via chemical etching or via laser etching.

12. The method of claim 11, wherein a line with a specific width is drawn around each of determined defects via laser etching wherein along the line the TCO layer is removed thereby ensuring that after the passivation step the TCO layer in electrical contact with the defects for which the positions have been determined has no electrical contact to the remaining TCO layer used as an electrode.

13. The method of any of claims 1 to 12, wherein the photovoltaic element is a roll-to-roll thin film solar cell.

14. Method for passivating defects causing leakage currents in a photovoltaic element comprising the steps of:
(i) illuminating an area, having at least a minimum size, of the photovoltaic element;
(ii) determining a position of a defect based on at least one photoinduced electrical value between electrodes of the photovoltaic element and a corresponding measurement position within the illuminated area on one of the electrodes of the photovoltaic element; and
(iii) removing at least one of the electrodes in an area at the determined position of the defect via etching.

15. The method of claim 14 further comprising the step of:
(iia) positioning the photovoltaic element at the determined position,
wherein the at least one of the electrodes is a TCO layer, the defect is a shunt and step (iii) comprises removing the TCO layer in an area at the determined position of the shunt via etching thereby ensuring that the shunt has no electrical contact to a front electrode after removing the TCO layer.

16. System for localizing defects causing leakage currents in a photovoltaic element comprising:
illuminating means for illuminating an area, having at least a minimum size, of the photovoltaic element;
measurement means for measuring at least one photoinduced electrical value between electrodes of the photovoltaic element at at least one specific measurement position within the illuminated area on one of the electrodes of the photovoltaic element; and determining means for determining a position of a defect based on the measured at least one photoinduced electrical value and the at least one specific measurement position.

17. The system of claim 16 wherein the measurement means comprises at least one measuring contact for measuring the at least one electrical value on one of the electrodes of the photovoltaic element, wherein the electrical value is a photoinduced electrical value and wherein the measurement means is further adapted to move the photovoltaic element in relation to the at least one measuring contact for measuring a number of photoinduced electrical values at different measurement positions and to store the measured at least one photoinduced electrical value in correlation with the at least one specific measurement position.

18. The system of claims 16 and 17, wherein the determining means further comprises:
voltage profile determining means for determining a position dependent voltage profile for an electrical potential based on the measured at least one photoinduced electrical value and the corresponding at least one specific measurement position; and minimum determining means for determining a minimum or maximum of the position dependent voltage profile and providing a position of the determined minimum or maximum as a position of the defect.
